# EUROPÄISCHE PATENTANMELDUNG

(11) **EP 2 677 326 A1**
(43) Veröffentlichungstag der Anmeldung: **25.12.2013**
(21) Anmeldenummer: 12172426.4
(22) Anmeldetag: 18.06.2012
(51) Int. Cl.: G01R 31/28

(54) **Vorrichtung zum Prüfen von elektronischen Bauteilelementen**

(71) Anmelder: Multitest elektronische Systeme GmbH, 83026 Rosenheim (DE)
(72) Erfinder: Lorenz, Bernhard, 85417 Marzling (DE)
(74) Vertreter: Dilg, Haeusler, Schindelmann Patentanwaltsgesellschaft mbH

(57) **Zusammenfassung**

Die Erfindung geht aus von einer Vorrichtung zum Prüfen von elektronischen Bauteilelementen, die auf ein Substrat (9) aufgebracht sind, mit Prüfnadeln (12), die auf Kontaktflächen des Substrats (9) aufsetzbar sind. Erfindungsgemäß ist eine rahmenartige Stützstruktur (14) vorgesehen, die das Substrat (9) so abstützt, dass sich die einzelnen Bauteilelemente (10) in Freiräumen der Stützstruktur (14) befinden.

## Beschreibung

Die Erfindung betrifft eine Vorrichtung zum Prüfen von elektronischen Bauteilelementen nach dem Oberbegriff von Anspruch 1.

Um Platz auf Leiterplatten einsparen zu können, soll die Integrationsdichte von elektronischen Bauteilen immer weiter erhöht werden. Zu diesem Zweck werden seit kurzer Zeit verschiedene Bauteilelemente vertikal gestapelt und dreidimensional miteinander zu sogenannten 3D-ICs verschaltet. Die vertikale Verbindung der einzelnen Bauteilelemente wird bevorzugt über die TSV-Technologie (Through-Silicon-Via) realisiert. Bei der TSV-Technologie wird die Verbindung zwischen den einzelnen horizontalen Schichten durch vertikale metallische Verbindungen mit einem Durchmesser von ca. 5 µm geschaffen. Diese 3D TSV-ICs sind bezogen auf ihre Grundfläche hoch integriert und verhalten sich äußerst robust.

Die durch die hohe Integration bedingte größere Ausschussrate lässt sich dadurch minimieren, dass nicht nur die fertigen ICs geprüft werden, sondern wenn der Stapel immer dann getestet wird, wenn ein neues Bauteilelement mit dem bereits bestehenden Stapel verbunden und durchkontaktiert wurde. So lassen sich viele Fehler in einer sehr frühen Phase der Herstellung erkennen und möglicherweise sogar reparieren.

Die ICs befinden sich bis zu ihrer Fertigstellung auf dem Substrat und werden erst danach durch Zersägen vereinzelt. Die Zwischentests vor der Fertigstellung der einzelnen ICs müssen also auf dem Substrat erfolgen.

Die Kontakte, auf die die Prüfnadeln aufsetzen können, befinden sich auf der Rückseite des Substrats gegenüber den Bauteilstapeln. Bei einer Anzahl bis zu 1000 Prüfkontakten und einer notwendigen Andruckkraft von ca. 0,2 N pro Prüfnadel, ergibt sich eine Kraft von ca. 200 N, die auf die sehr geringe Fläche eines ICs drückt. Da das Substrat sehr dünn ist, entstehen innerhalb des Substrats große mechanische Spannungen, die Beschädigungen hervorrufen können.

Der Erfindung liegt die Aufgabe zugrunde, eine Vorrichtung zum Prüfen von elektronischen Bauteilelementen, die auf ein Substrat aufgebracht sind, so auszugestalten, dass eine Vielzahl von Prüfschritten während der Herstellung der Bauteilelemente auf dem Substrat durchgeführt werden kann, ohne dabei Beschädigungen des Substrats, der Bauteilelemente und/oder der Verbindung zwischen Substrat und Bauteilelementen hervorzurufen.

Gelöst wird die Aufgabe gemäß der Erfindung durch eine Vorrichtung zum Prüfen von elektronischen Bauteilelementen mit den Merkmalen von Anspruch 1. Als elektronische Bauteilelemente werden alle fertigen Bauteile, aber auch Bauteile während der Herstellung bezeichnet, auf die noch weitere Schichten aufgebracht werden, oder die noch mit weiteren Bauteilen in einem vertikalen Stapel verbunden werden.

Weitere Einzelheiten und Vorteile der Erfindung ergeben sich aus den Unteransprüchen.

Erfindungsgemäß ist eine rahmenartige Stützstruktur vorgesehen, die das Substrat so abstützt, dass sich die einzelnen Bauteilelemente in Freiräumen der Stützstruktur befinden. Die rahmenartige Stützstruktur kann durch einen geschlossenen Rahmen gebildet werden, sie kann aber auch aus einzelnen Abschnitten bestehen, die die Teile des Substrats unterstützen, auf denen keine Bauteilelemente aufgebracht sind. Das Substrat liegt mit solchen Bereichen auf der rahmenartigen Stützstruktur auf, in denen es später, zur Vereinzelung der fertigen Bauteilelemente, gesägt wird.

Das Substrat ist auf diese Weise so gelagert, dass auf die sehr empfindlichen Bauteilelemente selbst keine direkten Kräfte einwirken, da sowohl die rahmenartige Stützstruktur einen Abstand von den Seitenwänden der Bauteilelemente aufweist, als auch der Boden der Stützstruktur einen Abstand von der Fläche der Bauteilelemente aufweist, auf die noch weitere Schichten aufgebracht werden sollen. Der Druck der Prüfnadeln kann auf so über die rahmenartige Stützstruktur abgeleitet werden, ohne dass die Bauteilelemente oder das Substrat dabei beschädigt werden.

Vorteilhaft ist die rahmenartige Stützstruktur um eine Gruppe von Bauteilelementen herum angeordnet. So eine Gruppe kann beispielsweise durch eine Reihe von Bauteilelementen auf dem Substrat gebildet werden. Bei Bauteilelementen mit einer relativ geringen Anzahl von Kontakten, die dementsprechend mit weniger Prüfnadeln kontaktiert und mit geringerer Kraft belastet werden, kann es aber auch ausreichend sein, die rahmenartige Stützstruktur um eine andere Gruppe von Bauteilelementen herum, beispielsweise ein Array von vier Bauteilelementen, anzuordnen.

Wird auf einem Substrat immer nur eine Reihe von Bauteilelementen gleichzeitig geprüft, so kann es sinnvoll sein, die Gruppen für die rahmenartige Stützstruktur aus den senkrecht dazu angeordneten Zeilen von Bauteilelementen zu bilden. Durch diese Maßnahme wird das Substrat über der rahmenartigen Stützstruktur für eine Gruppe von Bauteilelementen nur immer mit der Kraft der Prüfnadeln für ein einzelnes Bauteilelement gleichzeitig belastet.

Die Anzahl und Anordnung von Bauteilelementen auf einem Substrat sind sehr unterschiedlich und hängen von der Art der Bauteilelemente ab. Bei einem großen Abstand zwischen den Bauteilelementen nach allen Seiten, also zu jedem der benachbarten Bauteilelemente, oder bei einer großen Druckkraft der Prüfnadeln ist es sinnvoll, dass die rahmenartige Stützstruktur um jedes Bauteilelement herum angeordnet ist. Dadurch ist an jeder Seite eines jeden Bauteilelements eine Unterstützung für das Substrat vorgesehen und der Druck der Prüfnadeln kann noch besser aufgefangen werden. Diese Maßnahme ist besonders dann wichtig, wenn die Bauteilelemente des Substrats nicht gleichzeitig sondern nacheinander geprüft werden.

Bei einer gleichzeitigen Prüfung mehrerer Bauteile kann es insbesondere bei den äußeren Bauteilen dazu kommen, dass durch den Druck der Prüfnadeln auf die Kontaktflächen der freie Rand des Substrats leicht in Richtung der Prüfnadeln kippt und dadurch im Bereich des Bauteilelements eine leichte Durchbiegung im Substrat erzeugt wird. In bestimmten Fällen kann es folglich trotz einer rahmenartigen Stützstruktur zu Beschädigungen des Substrats, des Bauteilelements oder der Verbindung zwischen Substrat und Bauteilelement kommen. Es ist deshalb besonders vorteilhaft wenigstens ein der Stützstruktur gegenüberliegendes Klemmelement vorgesehen, welches in seiner Klemmstellung das Substrat senkrecht zur Substratebene auf die rahmenartige Stützstruktur presst und dort festhält.

Durch diese Klemmung wird das Kippen des freien Rands des Substrats verhindert, so dass dadurch auch die Durchbiegung des Substrats stark reduziert werden kann. Das Klemmelement kann, genauso wie bei der rahmenartigen Stützstruktur selbst, eine rahmenartige Struktur aufweisen, oder es können mehrere einzelne Klemmelemente verwendet werden, die zusammen gesehen ebenfalls eine rahmenartige Stützstruktur ergeben.

Vorteilhaft ist die rahmenartige Stützstruktur oder das wenigstens eine Klemmelement vorgespannt. Durch diese Maßnahme lässt sich die Klemmkraft genau einstellen. Die Klemmkraft ist so einzustellen, dass eine sichere Fixierung des Substrats die beschriebenen Spannungseffekte verhindert, dass aber keine zerstörerischen Kräfte auf das Substrat wirken. Die Vorspannung lässt sich beispielsweise durch eine Feder, insbesondere eine Blattfeder, oder aber durch ein Elastomer-Formteil erzeugen.

Erfindungsgemäß baut das wenigstens eine Klemmelement eine Klemmkraft auf, bevor die Prüfnadeln auf die Kontaktflächen des Substrats aufsetzen. Dies lässt sich dadurch erreichen, dass der Abstand zwischen dem wenigstens einen Klemmelement und dem Substrat geringer als der Abstand zwischen den Prüfnadeln und den Kontaktflächen des Substrats ist. Wenn sich nun die rahmenartige Stützstruktur mit dem Substrat auf die Prüfnadeln zubewegt, setzt zuerst das wenigstens eine Klemmelemente auf dem Substrat auf und klemmt dieses mit der eingestellten Vorspannung zwischen dem wenigstens einen Klemmelement und der rahmenartigen Stützstruktur ein. Erst dann setzen die Prüfnadeln auf die Kontaktflächen des Substrats auf. Besonders vorteilhaft ist deshalb das wenigstens eine Klemmelement vorgespannt und in den Prüfsockel integriert oder zumindest fest mit diesem verbunden.

Der Prüfsockel mit den Prüfnadeln ist üblicherweise über ein Loadboard mit einem Testkopf verbunden. Dieser Testkopf wiederum steht über eine Vielzahl von Leitungen mit einem Rechner in Verbindung. Der Testkopf zusammen mit dem Prüfsockel wird deshalb in seiner Lage fixiert und ist nicht beweglich. Vorteilhaft wird deshalb die rahmenartige Stützstruktur mit dem aufliegenden Substrat von einem Druckstempel gegen das wenigstens eine Klemmelement und die Prüfnadeln gedrückt.

Vorteilhaft presst das wenigstens eine Klemmelement das Substrat auf die rahmenartige Stützstruktur, die um eine Gruppe von Bauteilelementen herum angeordnet ist. Diese Gruppe von Bauteilelementen kann aus einer Reihe von Bauteilelementen, einem Array von beispielsweise vier Bauteilelementen, oder aber aus allen Bauteilelementen auf dem Substrat bestehen.

Bei Bauteilelementen, die zwischen anderen Bauteilelementen angeordnet sind, kann es nicht zu einer so starken Verformung des Substrat kommen, da auch die Kraft der Prüfnadeln, die auf die benachbarten Bauteilelemente drücken, die Umgebung dieses Bauteils in Richtung der rahmenartigen Stützstruktur drücken. Bei Bauteilelementen dagegen, die am Rand einer Gruppe angeordnet sind und daher zumindest auf einer Seite keine oder nur weit entfernte Nachbarbauteilelemente besitzen, existiert diese Kraft nur an den Seiten mit Nachbarbauteilelementen, nicht aber an der "offenen" Seite oder den "offenen" Seiten. Es ist daher insbesondere wichtig das Substrat in dem Bereich zu klemmen, der um eine Gruppe von Bauteilelementen herum angeordnet ist.

Sind insbesondere kleine Bauteile in größerem Abstand auf dem Substrat verteilt, kann es sinnvoll sein, das Substrat um jedes Bauteil herum zu klemmen. Gerade wenn eine große Anzahl von Prüfnadeln benötigt wird und dadurch an einer relativ kleine Stelle eine hohe Andruckkraft auf das Substrat wirkt, kann durch diese Maßnahme die Spannung im Substrat, aber auch an der Verbindungsstelle zwischen Substrat und Bauteil reduziert werden. Das wenigstens eine Klemmelement presst deshalb vorteilhaft das Substrat auf die rahmenartige Stützstruktur, die um jedes Bauteilelement herum angeordnet ist.

Ist das wenigstens eine Klemmelement an einer oder an mehreren Stellen besonders breit ausgelegt, um eine möglichst hohe Klemmwirkung zu erzielen, muss unbedingt verhindert werden, dass Kippmomente auf das Substrat wirken. Ein Teil des wenigstens einen Klemmelements, der die rahmenartige Stützstruktur in der Breite überragt, stützt sich deshalb auf wenigstens zwei parallelen Teilen der rahmenartigen Stützstruktur ab. Durch diese Maßnahme können Kippmomente sicher vermieden werden.

Weitere Einzelheiten und Vorteile der Erfindung ergeben sich aus der Beschreibung eines Ausführungsbeispiels, das anhand der Zeichnung eingehend erläutert wird.

Es zeigt:
- Fig. 1: eine schematische Ansicht einer erfindungsgemäßen Vorrichtung zum Prüfen von elektronischen Bauteilelementen, die auf ein Substrat aufgebracht sind,
- Fig. 2: Aufsichten auf verschiedene rahmenartige Stützstrukturen für das Substrat,
- Fig. 3: die Aufsicht auf ein Substrat mit zu prüfenden elektronischen Bauteilelementen,
- Fig. 4: einen Schnitt durch einen Teil des Prüfsockels und der rahmenartigen Stützstruktur und
- Fig. 5: eine Seitenansicht einer Ausführungsform der rahmenartigen Stützstruktur und der Klemmelemente.

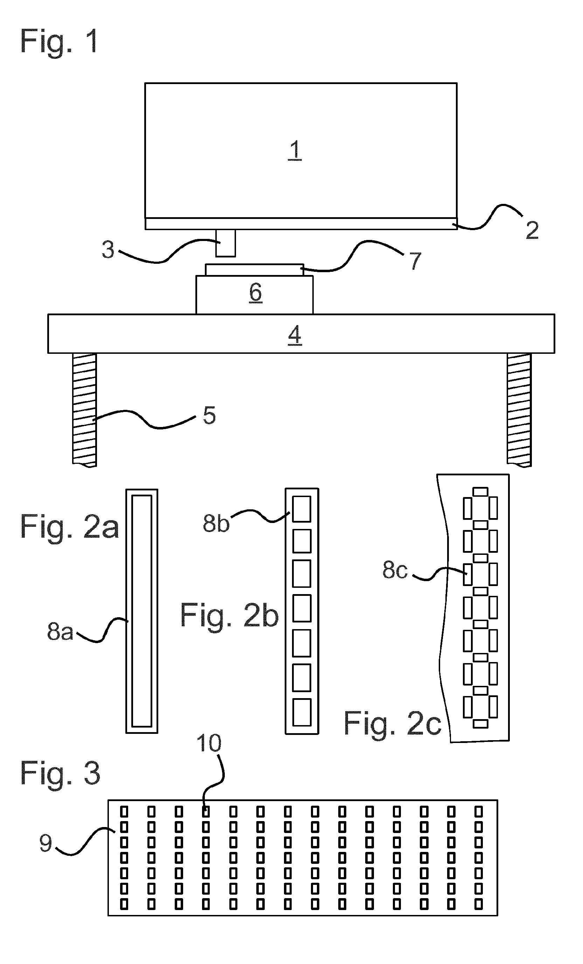

Die in Fig. 1 dargestellte Vorrichtung weist einen Druckstempel 5 auf, der mit Hilfe der Gewindestangen 8 gleichmäßig nach oben und unten bewegt werden kann. Auf dem Druckstempel ist das Nest 6 vorgesehen, welches eine Aufnahme 7 für das in dieser Darstellung nicht sichtbare Substrat enthält und zusammen mit einer hier nicht gezeigten X-Y-Verschiebeeinrichtung eine Positionier- und Halteeinrichtung für das Substrat 9 (siehe Fig. 3) bildet.

Mit Hilfe des Nests 6 kann das Substrat 9 hochgenau unterhalb des Prüfsockels 3 positioniert werden. Auf dem Substrat 9 sind die in Fig. 3 dargestellten Bauteilelemente 10 aufgebracht.

Über dem Druckstempel 5 und dem Nest 6 ist der Testkopf 1 als festes, unbewegliches Modul montiert. Die Verbindung zwischen dem Testkopf 1 und dem Prüfsockel 3 wird durch das Loadboard 2 geschaffen.

Zum Prüfen der Bauteilelemente 10 wird der Druckstempel 5 nach oben gefahren und die Kontakte auf dem Substrat 9 werden mit großer Kraft gegen die Prüfnadeln des Prüfsockels 3 gedrückt. Die Bauteilelemente 10 sind gegenüber den Kontakten, auf der Unterseite des Substrats aufgebracht.

In Fig. 2 sind unterschiedliche Klemmelemente 8a - c gezeigt, die in den Prüfsockel 3 integriert sind. Auch die Aufnahme 7 weist eine Struktur auf, wie sie aus den Figuren 2a - 2c hervorgeht. Sind die Bauteilelemente 10, wie in Fig. 3 dargestellt, reihenweise auf dem Substrat 9 aufgebracht, so bieten sich für die Aufnahme 7 rahmenartige Strukturen, entsprechend der in Fig. 2a dargestellten Form, für die Auflage des Substrats an.

Werden viele Prüfnadeln benötigt und es wird dadurch jedes Bauteilelement 10 mit einer großen Kraft beaufschlagt, so ist es besser, das Substrat 9 auf allen Seiten jedes einzelnen Bauteilelements 10 zu unterstützen. Eine entsprechende Form der rahmenartigen Stützstruktur ist in Fig. 2b gezeigt. Bei einer Abwandlung der rahmenartigen Stützstruktur entsprechend Fig. 2b ist eine Platte vorgesehen, die für jedes Bauteilelement 10 eine entsprechende Öffnung aufweist. Die Öffnungen der Stützstrukturen sind so dimensioniert, dass die Grenzflächen der Bauteilelemente 10 nicht berührt werden.

Die rahmenartige Stützstruktur muss jedoch keine in sich geschlossene Struktur bilden. Die in Fig. 2c gezeigte Form ist ebenso möglich. Die dort dargestellte Struktur kann sich nach links fortsetzen, so dass ein Gitter entsteht in dessen Öffnungen alle Bauteilelemente 10 des Substrats 9 aufgenommen werden können. Es kann aber ebenso für jede Reihe der Bauteilelemente 10 auf dem Substrat 9 eine eigene rahmenartige Stützstruktur, wie sie in den Figuren 2a-c gezeigt sind, vorgesehen sein.

In dem Prüfsockel 3 ist wenigstens ein Klemmelement 8a - c integriert. Üblicherweise werden mit dem Prüfsockel 3 immer mehrere Bauteilelemente 10 gleichzeitig geprüft. Das Klemmelement soll zumindest so beschaffen sein, dass das Substrat 9 immer um die gleichzeitig zu prüfenden Bauteilelemente herum geklemmt wird. So ist beispielsweise das Klemmelement 8a dafür vorgesehen, dass eine Reihe der Bauteilelemente 10 auf dem Substrat 9 gleichzeitig geprüft wird. Bei einer großen Anzahl von Prüfnadeln ist es sinnvoll ein Klemmelement zu verwenden, welches das Substrat nicht nur außen um die gleichzeitig zu prüfenden Bauteilelemente herum klemmt, sondern wie die Klemmelemente 8b und 8c das Substrat 9 auch zwischen den gleichzeitig zu prüfenden Bauteilelementen klemmt.

Da das Substrat 9 während der Prüfung der Bauteilelemente 10 in der Aufnahme 7 fixiert ist, muss die rahmenartige Stützstruktur so ausgelegt sein, dass das Substrat 9 während der gesamten Prüfung an den relevanten Stellen unterstützt ist. Bei der Klemmung muss dagegen nur das ganze Substrat berücksichtigt werden, wenn ein Prüfsockel verwendet wird, der alle Bauteilelemente 10 zur gleichen Zeit prüft. Wird aber nur eine Gruppe von Bauteilelementen gleichzeitig geprüft, sei es nun eine Reihe oder ein Array an Bauteilementen, muss das Substrat auch nur in diesem Bereich geklemmt werden. Ähnlich verhält es sich bei einer Einzelprüfung. Werden alle Bauteilelemente 10 nacheinander geprüft, so wird nur der das zu prüfende Bauteil umgebende Bereich des Substrats geklemmt.

Die Form der Klemmelemente und die Form der rahmenartigen Stützstruktur müssen nur aufeinander abgestimmt sein. So kann es sinnvoll sein, bei einer gitterförmigen rahmenartigen Stützstruktur, die das Substrat um jedes Bauteil herum abstützt, ein Klemmelement zu verwenden, das dem in Fig. 2a gezeigten Klemmelement entspricht. Insbesondere wenn mit dem Prüfsockel 3 immer eine Reihe der Bauteilelemente 10 auf dem Substrat 9 gleichzeitig geprüft werden soll, ist diese Kombination angebracht.

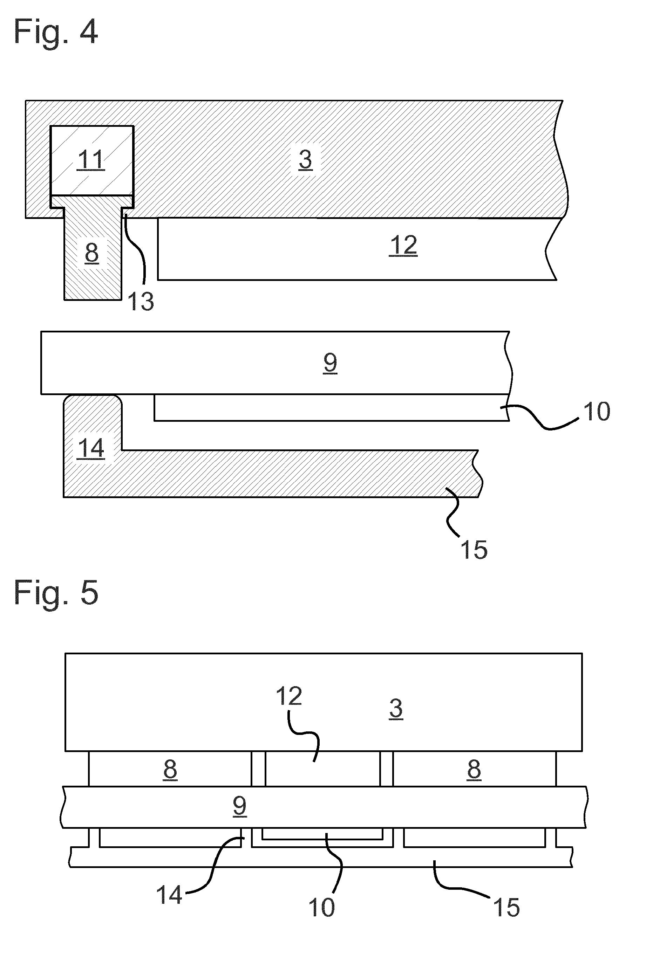

Weitere Details der erfindungsgemäßen Vorrichtung sind in Fig. 4 gezeigt. Der Prüfsockel 3 besitzt eine Ausnehmung, in die ein Elastomer-Element 11 eingesetzt ist. Das Elastomer-Element 11 hält das Klemmelement 8 unter Vorspannung, während der Flansch 13 verhindert, dass das Klemmelement 8 von dem Elastomer-Element 11 aus der Ausnehmung des Prüfsockels 3 herausgedrückt wird. Die Prüfnadeln 12, die hier nur schematisch als Block dargestellt sind, stehen ebenfalls unter Vorspannung. Ihr Abstand zu dem Substrat 9 ist jedoch größer als der Abstand des Klemmelements 8 zum Substrat 9.

Das Substrat 9 liegt auf dem Auflage-Schenkel 14 der rahmenartigen Stützstruktur. Die rahmenartige Stützstruktur ist so dimensioniert, dass das Bauteilelement 10 an der Unterseite des Substrats 9 nirgends berührt wird. Auch die Grundfläche 15 besitzt einen entsprechenden Abstand von dem Bauteilelement 10.

Wird nun der Druckstempel 4 mit dem Nest 6 und der Auflage 7 (siehe Fig. 1) nach oben gefahren, so berührt das Substrat 9 zuerst das Klemmelement 8. Die Klemmkraft die durch das Elastomer-Element 11 eingestellt ist, wirkt sofort und fixiert das Substrat 9 noch bevor die Prüfnadeln 12 auf die Kontaktflächen des Substrats 9 aufsetzen. Eine evtl. Durchbiegung des Substrats 9 im Bereich der Prüfnadeln 12 kann dadurch stark reduziert werden.

In Fig. 5 ist eine weitere mögliche Kombination zwischen rahmenartiger Stützstruktur und Klemmelement gezeigt. In dem dargestellten Ausführungsbeispiel sollen immer die Bauteile einer Reihe auf dem Substrat 9 gleichzeitig geprüft werden. Der Prüfsockel 3 weist hierzu eine große Anzahl von Prüfnadeln 12 auf, die entsprechend der Reihe der zu prüfenden Bauteilelemente 10 angeordnet sind. Die rahmenartige Stützstruktur bildet mit ihren Auflage-Schenkeln 14 und der Grundfläche 15 in der Aufsicht ein gitterartiges Netz.

Wie in Fig. 3 gezeigt, weisen die einzelnen Reihen von Bauteilelementen einen größeren Abstand auf, als die Bauteilelemente einer Reihe untereinander. Die Klemmelemente 8 sind hier so breit dimensioniert, dass sie über zwei parallele Auflage-Schenkel 14 reichen. Auf diese Weise kann eine hohe Haltekraft erreicht werden ohne dass durch die Klemmelemente 8 Kippmomente in das Substrat 9 eingebracht werden könnten.

### Bezugszeichenliste:

- 1: Testkopf
- 2: Loadboard
- 3: Prüfsockel
- 4: Druckstempel
- 5: Gewindestangen
- 6: Nest
- 7: Aufnahme mit rahmenartiger Stützstruktur
- 8: Klemmelemente
- 9: Substrat
- 10: Bauteilelement
- 11: Elastomer-Element
- 12: Prüfnadeln
- 13: Flansch
- 14: Auflage-Schenkel
- 15: Grundfläche

## Patentansprüche

1. Vorrichtung zum Prüfen von elektronischen Bauteilelementen, die auf ein Substrat (9) aufgebracht sind, mit Prüfnadeln (12), die auf Kontaktflächen des Substrats (9) aufsetzbar sind, **dadurch gekennzeichnet, dass** eine rahmenartige Stützstruktur (14) vorgesehen ist, die das Substrat (9) so abstützt, dass sich die einzelnen Bauteilelemente (10) in Freiräumen der Stützstruktur (14) befinden.

2. Vorrichtung nach einem der Ansprüche 1, **dadurch gekennzeichnet, dass** die rahmenartige Stützstruktur (14) um eine Gruppe von Bauteilelementen (10) herum angeordnet ist.

3. Vorrichtung nach einem der Ansprüche 1 bis 2, **dadurch gekennzeichnet, dass** die rahmenartige Stützstruktur (14) um jedes Bauteilelement (10) herum angeordnet ist.

4. Vorrichtung nach einem der Ansprüche 1 bis 3, **dadurch gekennzeichnet, dass** wenigstens ein der Stützstruktur (14) gegenüberliegendes Klemmelement (8) vorgesehen ist, welches in seiner Klemmstellung das Substrat (9) senkrecht zur Substratebene auf die rahmenartige Stützstruktur (14) presst und dort festhält.

5. Vorrichtung nach einem der Ansprüche 1 bis 4, **dadurch gekennzeichnet, dass** die rahmenartige Stützstruktur (14) oder das wenigstens eine Klemmelement (8) vorgespannt ist.

6. Vorrichtung nach einem der Ansprüche 1 bis 5, **dadurch gekennzeichnet, dass** das wenigstens eine Klemmelement (8) eine Klemmkraft aufbaut bevor die Prüfnadeln (12) auf die Kontaktflächen des Substrats (9) aufsetzen.

7. Vorrichtung nach einem der Ansprüche 1 bis 6, **dadurch gekennzeichnet, dass** sich die rahmenartige Stützstruktur (14) mit dem aufliegenden Substrat (9) von einem Druckstempel (4) gegen das wenigstens eine Klemmelement (8) und die Prüfnadeln (12) gedrückt wird.

8. Vorrichtung nach einem der Ansprüche 1 bis 7, **dadurch gekennzeichnet, dass** das wenigstens eine Klemmelement (8) das Substrat (9) auf die rahmenartige Stützstruktur (14) presst, die um eine Gruppe von Bauteilelementen (10) herum angeordnet ist.

9. Vorrichtung nach einem der Ansprüche 1 bis 8, **dadurch gekennzeichnet, dass** das wenigstens eine Klemmelement (8) das Substrat (9) auf die rahmenartige Stützstruktur (14) presst, die um jedes Bauteilelement (10) herum angeordnet ist.

10. Vorrichtung nach einem der Ansprüche 1 bis 9, **dadurch gekennzeichnet, dass** ein Teil des wenigstens einen Klemmelements (8), der die rahmenartige Stützstruktur (14) in der Breite überragt, sich auf wenigstens zwei parallelen Teilen der rahmenartigen Stützstruktur (14) abstützt.
